# FASCICULE DE BREVET EUROPEEN

(11) **EP 2 962 390 B1**
(45) Date de publication et mention de la délivrance du brevet: **08.06.2022**
(21) Numéro de dépôt: 14713769.9
(22) Date de dépôt: 27.02.2014
(51) Int. Cl.: H03F 3/21, H03F 3/72, H03F 3/45

(54) **SYSTÈME D'AMPLIFICATION DE SIGNAUX**
SIGNALVERSTÄRKUNGSSYSTEM
SIGNAL AMPLIFICATION SYSTEM

(30) Priorité: 28.02.2013 FR 1300453
(43) Date de publication de la demande: 06.01.2016
(73) Titulaire: Thales, 92400 Courbevoie (FR); Institut Polytechnique de Bordeaux, 33400 Talence (FR); Université de Bordeaux, 33000 Bordeaux (FR); Centre National de la Recherche Scientifique (C.N.R.S.), 75016 Paris (FR)
(72) Inventeur: GARREC, Patrick, 33700 Merignac (FR); KERHERVE, Eric, 33600 Pessac (FR); CORNIC, Pascal, 29820 Guilers (FR); KEMKEMIAN, Stéphane, 78851 Elancourt Cedex (FR); DEMIREL, Nejdat, 33600 Pessac (FR); MANCUSO, Yves, 92350 Le Plessis-Robinson (FR)
(74) Mandataire: Marks & Clerk France
(86) Numéro de dépôt international: PCT/EP2014/053866
(87) Numéro de publication internationale: WO 2014/131849

(56) Documents cités:
- EP-A1- 2 159 912
- WO-A1-2008/099464
- US-A- 5 834 975
- US-A1- 2008 106 331
- US-A1- 2009 115 512
- US-A1- 2009 153 250
- US-A1- 2010 225 398
- US-A1- 2012 081 182
- US-A1- 2012 105 147
- US-A1- 2012 154 054
- US-B1- 7 656 227

## Description

La présente invention concerne un système d'amplification de signaux en émission dont la bande d'étalement des fréquences est importante typiquement de plusieurs octaves, (plus de quatre par exemple) et/ou peut varier dans le temps. Ce type de système est utilisé en particulier dans des systèmes comportant un ensemble de capteurs, ou plus généralement d'émissions ayant des fonctions différentes ou comportant un ensemble d'antennes. Les signaux en provenance des différentes émissions ont généralement une bande d'étalement des fréquences variable dans le temps.

On connait des systèmes permettant l'amplification de signaux, dont la bande d'étalement des fréquences est importante. Cependant, ces systèmes ont l'inconvénient de provoquer un excès de consommation énergétique, lorsqu'ils sont utilisés pour l'amplification de signaux ayant une bande d'étalement des fréquences étroite typiquement moins d'une octave. Dans le cas de signaux ayant une bande d'étalement des fréquences étroite, le rendement de ces systèmes est alors très mauvais, il est alors nécessaire d'augmenter la puissance des circuits d'émission. Cette augmentation engendre une nécessité de refroidir ces systèmes, dispositif de refroidissement qui est également consommateur d'énergie.

On connait des systèmes, comme la demande de brevet international WO 2008/099464 A1, présentant deux moyens d'amplification dont la bande d'étalement est différente, seulement l'utilisation de ces moyens est exclusive. D'autres systèmes, tel que décrit par exemple dans la demande de brevet US 2012/0154054 A1, présentent plusieurs moyens d'amplification sélectionnés en fonction du gain recherché.

Le document EP2159912 décrit un système d'amplification de type Doherty comprenant un amplificateur principal à bande relativement large et deux amplificateurs auxiliaires à bande plus étroite. Les amplificateurs auxiliaires fonctionnent de manière mutuellement exclusive ; leurs bandes sont incluses dans celle de l'amplificateur principal. Ce système d'amplification présente une bande assez étroite, très inférieure à une octave, notamment en raison de l'utilisation de déphaseurs à quart d'onde.

Il est connu des systèmes comportant un ensemble de capteurs ayant des fonctions différentes ou comportant un ensemble d'antennes et qui répartissent les signaux reçus dans différentes sous-bandes. Ces systèmes amplifient alors les signaux par sous-bandes. Cependant ces systèmes ne sont pas adaptatifs en fréquences et/ou en puissance et rendement, et ne peuvent donc pas s'adapter à l'amplification de signaux dont la bande d'étalement des fréquences n'est pas connue a priori.

La commutation de classe est une opération connue pour augmenter le rendement des amplificateurs.

La présente invention vise donc à remédier à ces problèmes en proposant un système d'amplification adaptatif à la fois en fréquence et en puissance, et en forme de signal (par forme de signal on entend classe, type de modulation ou type d'impulsion), dont le rendement est optimal pour un ensemble de bande d'étalement des fréquences.

Ainsi il est proposé, selon un aspect de l'invention, un système d'amplification de signaux d'entrée comportant au moins deux moyens d'amplification différents des signaux d'entrée. Le système comporte aussi un moyen de sommation des signaux amplifiés. Le système comporte aussi des moyens d'activation/désactivation dynamique d'un ou plusieurs des moyens d'amplification à partir des signaux d'entrée. L'invention est telle que définie dans la revendication 1.

Le système permet donc d'être adapté afin que le rendement soit optimal pour un ensemble de bandes différentes d'étalement des fréquences des signaux. Ainsi il est possible de choisir un des moyens d'amplification afin qu'il ait un rendement maximal pour un signal ayant une bande d'étalement des fréquences importante. Pour l'autre moyen d'amplification, il est possible de le choisir afin qu'il ait un rendement maximal pour un signal ayant une bande d'étalement des fréquences étroite. Ensuite les signaux amplifiés par les deux moyens d'amplification peuvent être sommés, ce qui permet au système d'être relié à une unique antenne. Les moyens d'extinction permettent eux de n'utiliser, à un instant donné, que les moyens d'amplification utiles. Ceci permet donc de limiter l'énergie utilisée par le système et de limiter l'échauffement de ce système. De plus ce système tel que décrit dans l'invention est compact parce qu'il peut être totalement intégré sur une seule puce microélectronique. En particulier le système occupe un volume dont la dimension caractéristique est de l'ordre de grandeur de la taille de la maille de l'antenne (8mm dans le cas d'une antenne permettant d'émettre un signal dont la fréquence de modulation est de 18GHz). La contrainte de compacité est encore plus importante lorsque l'on est en polarisation duale.

Avantageusement le système comporte en outre des moyens d'adaptation placés avant les moyens d'amplifications, lesdits moyens d'activation/désactivation étant en outre adaptés pour l'activation/désactivation desdits moyens d'adaptation.

Avantageusement le système comporte en outre des moyens de reconfiguration desdits deux moyens d'amplification.

Au moins deux des moyens d'amplification sont adaptés pour amplifier des signaux dont la bande d'étalement des fréquences est différente. Plus particulièrement, au moins un moyen d'amplification est adapté pour amplifier un signal dont la bande d'étalement a une largeur inférieure ou égale à une octave et un autre moyen d'amplification est adapté pour amplifier un signal dont la bande d'étalement a une largeur supérieure ou égale à une, voire à deux, et de préférence à quatre, octaves.

Selon une caractéristique technique au moins deux des moyens d'amplification sont réalisés en utilisant une technologie de fabrication différente.

Selon une caractéristique technique au moins un des moyens d'amplification est réalisé en utilisant du SiGe et au moins un des moyens d'amplification est réalisé en utilisant du GaN.

La fabrication peut être réalisée en SiGe, qui offre l'avantage d'un coût faible grâce à son utilisation intensive dans la téléphonie mobile et d'une forte intégration du fait du nombre élevé de couches de métallisation. Par contre ses tensions d'alimentation faibles ne permettent pas de sortir des puissances importantes. La fabrication peut aussi utiliser la technologie GaN, qui permet de disposer de puissances de sortie plus importantes avec un coût plus élevé à cause de sa moindre diffusion, cette technologie étant moins mature.

Selon une caractéristique technique au moins deux des moyens d'amplification utilisent une classe de fonctionnement différente.

Une classe de fonctionnement des amplificateurs est représentée par une lettre qui permet de caractériser les amplificateurs de cette classe. On peut distinguer les classes sinusoïdales (A, AB, B, C) des classes commutées (D, E, F, S).

Les classes sinusoïdales (A, AB, B, C) sont définies par la relation entre la forme du signal d'entrée et celle du signal de sortie et par la durée pendant laquelle un composant actif est utilisé lors de l'amplification d'un signal. Cette durée est mesurée en degrés ou en pourcentage de la période d'un signal sinusoïdal test appliqué à l'entrée de l'amplificateur, 100% ou 360 degrés représentant un cycle complet.

Pour les amplificateurs linéaires chaque classe définit la proportion du signal d'entrée qui est utilisée par chaque composant actif pour arriver au signal amplifié.
Classe A : La totalité du signal d'entrée (100 %) est utilisée.
Classe B : La moitié du signal (50 %) est utilisée.
Classe AB : Plus de la moitié mais pas la totalité du signal (50-100 %) est utilisée.
Classe C : Moins de la moitié (0-50 %) du signal est utilisée.

Avantageusement les moyens d'activation/désactivation sont adaptés pour l'activation des moyens d'amplification pour lesquels les performances sont optimales pour une bande d'étalement des fréquences associée auxdits signaux d'entrée.

Avantageusement les moyens d'activation/désactivation sont adaptés pour l'activation des moyens d'amplification pour lesquels les performances sont optimales pour une fréquence centrale associée auxdits signaux d'entrée.

Selon une caractéristique technique, au moins un des moyens d'amplification est adapté pour l'amplification de signaux constitués d'une porteuse pure modulée en phase et/ou amplitude et/ou fréquence et au moins un des moyens d'amplification et/ou lesdits moyens d'adaptation sont adaptés pour l'amplification de signaux constitués d'une succession d'impulsions.

L'intérêt de disposer d'un système d'amplificateurs hétérogènes est qu'il permet d'adapter dynamiquement le fonctionnement des amplificateurs au besoin et aux caractéristiques du signal à amplifier. Une émission continue modulée en phase et / ou en amplitude et/ou fréquence nécessite une alimentation constante. Une émission de pulse permet l'utilisation de réservoir d'énergie et s'apparente aux modulateurs.

La modification dynamique des circuits d'accord permet de faire du saut de fréquence et de s'adapter à la largeur de bande utile, en optimisant le rendement.

Un changement dynamique de la fréquence centrale est aussi possible. Ce changement va permettre de s'adapter à la fréquence à émettre et de se prémunir de la génération des harmoniques inhérentes à l'émission large bande.

Selon une caractéristique technique le système comporte en outre des moyens de mesure de la température interne du système. De plus les moyens d'activation/désactivation sont adaptés pour activer/désactiver au moins un des moyens d'amplification lorsque la température interne du système dépasse un seuil de température et/ou les moyens de reconfiguration sont adaptés pour reconfigurer au moins un des moyens d'amplification lorsque la température interne dépasse un seuil de température.

Cette caractéristique technique permet de prévenir le risque de surchauffe et de destruction du système. De plus elle permet de n'éteindre que certains des moyens d'amplification, lorsque le système est en surchauffe et permet au système de rester opérationnel.

La surveillance de la température interne, programmée en fonction de la technologie employée, permet de préserver le fonctionnement global et d'éviter une destruction du circuit, tout en délestant dynamiquement les fonctions jugées opérationnellement les moins critiques. Le choix des fonctions à délester est fait au cas par cas. La réduction de la puissance émise va diminuer la portée radar dans le ratio de 20% pour 3dB de baisse de puissance. Une adaptation dynamique de la puissance émise pour les liaisons de données peut même permettre de diminuer la puissance émise et de l'adapter au juste nécessaire pour satisfaire le besoin de liaison.

Selon une caractéristique technique le système comporte également au moins une antenne active à balayage électronique permettant l'émission desdits signaux sommés.

L'antenne active à balayage électronique est aussi connue sous l'appellation antenne réseau de modules actifs ou sous l'appellation anglaise « AESA » pour « Active Electronically Scanned Array ».

En Radar ou en télécommunication, une antenne à balayage électronique permet de diriger le faisceau de l'antenne dans une direction donnée en utilisant la mise en phase des signaux. Ceci permet de s'affranchir des moyens mécaniques de pointage. Une antenne réseau à commande de phase (phased array antenna en anglais) est un groupe d'antennes élémentaires alimentées avec des signaux dont la phase est ajustée de façon à obtenir le diagramme de rayonnement voulu. Généralement c'est un pointage du faisceau de l'antenne dans une direction donnée. Cette agilité de direction permet de pointer plusieurs cibles en même temps (à l'échelle du déplacement des cibles). Il est aussi possible de créer plusieurs sous faisceaux à l'émission et / ou à la réception.

Une antenne à balayage électronique passive réalise la formation du faisceau émis (ou reçu) grâce à un ensemble de dispositifs électroniques tels que des déphaseurs, des commutateurs, des atténuateurs. Le signal à émettre est distribué par un réseau ou par rayonnement à un ensemble de modules comportant déphaseur et élément rayonnant. Les dispositifs d'amplification des signaux émis ou reçus sont réalisés à l'extérieur de l'antenne.

Une antenne à balayage électronique active correspond à une antenne passive dont les dispositifs d'amplification des signaux émis ou reçus sont inclus dans l'antenne. Elle peut également contenir des dispositifs électroniques avancés de réception, comme la conversion de fréquence ou le codage des signaux, les déphasages peuvent être réalisés part des retards purs programmables. Par rapport à une antenne réseau, une antenne active est caractérisée par le fait que ces modules actifs sont placés entre les N éléments rayonnants et leurs sorties. L'ensemble de l'électronique est donc implémenté dans la maille du réseau.

L'invention sera mieux comprise et d'autres avantages apparaîtront à la lecture de la description détaillée faite à titre d'exemple non limitatif et à l'aide des figures parmi lesquelles :
La figure 1 présente un premier mode de réalisation du système présenté dans l'invention
La figure 2 présente une comparaison entre les performances du système présenté dans l'invention et les systèmes de l'état de la technique
La figure 3 présente un deuxième mode de réalisation du système présenté dans l'invention
La figure 4 présente un mode de réalisation des amplificateurs de puissance
La figure 5 présente la puissance de sortie du troisième mode de réalisation du système
La figure 6 présente le rendement du troisième mode de réalisation du système
La figure 7 présente le principe des commutations des dispositifs d'adaptation permettant de moduler dynamiquement la bande passante.
La figure 8 présente les performances du dispositif lors d'un changement dynamique de la fréquence centrale d'émission.
La figure 9, qui ne relève pas de l'invention est n'est présente qu'à titre illustratif, présente les performances du dispositif lors d'un changement dynamique bande passante du signal amplifié.

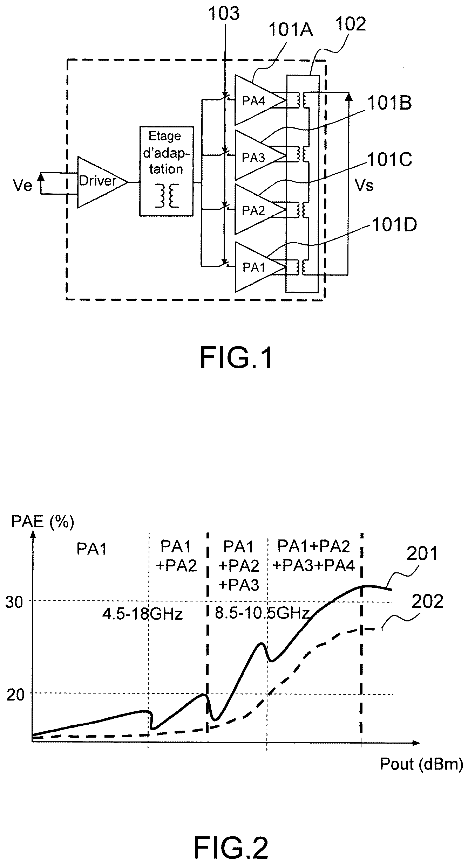

Le système décrit sur la figure 1 permet l'amplification d'un signal Ve entrant par la gauche du système et sortant en tant que signal amplifié Vs par la droite du système. Ce système comporte quatre amplificateurs de puissance (101.A, 101.B, 101.C et 101.D). Ces amplificateurs de puissance ont des caractéristiques différentes. Les amplificateurs ont une bande passante différente, et peuvent avoir une fréquence centrale différente et/ou une classe différente. Ils sont donc adaptés à l'amplification de signaux de caractéristiques différentes. Le système figure 1 comporte également un dispositif 102 de sommation des différents signaux en provenance des différents amplificateurs de puissance. Cette sommation est réalisée en utilisant un dispositif connu sous le nom anglais de DAT pour « Distributed Active Transformer » ou transformateur à distribution active. Ce dispositif de sommation permet d'augmenter la puissance du signal de sortie en sommant les signaux en provenance des différents amplificateurs de puissance. Ce dispositif de sommation a cependant l'inconvénient de présenter des pertes d'insertion. Ces pertes d'insertion dépendent de la bande passante que doit passer le dispositif de sommation. Pour une bande passante allant de la fréquence 8.5GHz à la fréquence 10.5 GHz, les pertes d'insertion sont inférieures à 0.7dB. Pour une bande passante allant de la fréquence 4.5 à la fréquence 18 GHz, les pertes d'insertion sont inférieures à 3dB. Le système décrit sur la figure 1 comporte également un dispositif 103 permettant l'extinction d'un ou plusieurs amplificateurs, lorsque ceux-ci ne sont pas utilisés. Par exemple, lorsque le signal à amplifier ne possède pas des caractéristiques qui correspondent à un des amplificateurs, celui-ci peut-être éteint. Cette extinction permet en particulier de limiter la consommation du système d'amplification, elle permet aussi de limiter l'échauffement de ce système.

Ce système comporte aussi un dispositif connu sous le nom anglais de Driver ou pré-étage d'amplification, qui permet d'adapter et de convertir les paramètres de puissance et d'impédance. Ce pré-étage permet également de réaliser le rôle de pré-étage d'amplification qui fournit la puissance d'entrée nécessaire à l'étage de puissance et le complément de gain à l'amplificateur global. Ce système comporte aussi un dispositif appelé étage d'adaptation qui permet l'adaptation de l'impédance en sortie du driver avec l'impédance en entrée des dispositifs d'amplification.

La figure 2 présente un graphique de la performance du système tel que présenté dans l'invention. La courbe en ligne discontinue présente la performance, exprimée par le rendement ou PAE pour « Power Added Efficiency » en anglais, des systèmes connus dans l'état de la technique en utilisant de la technologie GaN. La courbe pleine présente la performance du système suivant l'invention.

Le système permet donc de disposer d'un meilleur compromis entre la largeur de bande et le rendement de l'amplification. De plus le système permet de s'adapter en fonction de la bande de fréquence utilisée. Ce système permet donc l'amplification simultanée de deux types de signaux différents. Le premier signal peut par exemple avoir une forte puissance mais une bande restreinte d'étalement des fréquences. Ce type de signal est par exemple utilisé dans des radars connus sous l'acronyme anglais de SAR pour « Synthetic Aperture Radar ». Le deuxième signal peut par exemple avoir une bande d'étalement des fréquences large, mais une faible puissance. Ce deuxième type de signal est par exemple utilisé pour des applications de type télécommunication. Le temps durant lequel le système amplifie le premier signal radar est de l'ordre de 10 à 20% du temps total. La puissance dans ce cas a besoin d'être maximale car l'atténuation en espace libre varie en fonction de l'équation 1/R⁴ où R est la distance parcourue par le signal. La puissance nécessaire est donc supérieure à la puissance utilisée pour l'émission du deuxième signal de communication. En effet dans le cas du deuxième type de signal, l'atténuation varie en fonction de l'équation 1/R². Dans le cas du radar l'énergie est rétrodiffusée par la cible et parcourt deux fois le trajet. Dans le cas d'un signal de communication les pertes sont celles d'un trajet simple. On a donc besoin de plus d'énergie dans le cas du radar que dans le cas de la communication. Un mauvais rendement dans le cas du radar est plus pénalisant car il est multiplié par un chiffre significatif. Lorsque l'on utilise une puissance maximum, il est important d'optimiser le rendement.

Un tel système permet donc d'obtenir le meilleur compromis entre la bande d'étalement des fréquences que le système peut passer et le rendement du système. Ceci est obtenu par l'adaptabilité du système qui permet d'optimiser le rendement en fonction de l'utilisation de la puissance. Ce système est donc adapté à une utilisation dans un système multifonctions. Pour des besoins de communication nous pouvons nous limiter à des circuits large bande de rendement faible; mais les puissances demandées sont aussi faibles et donc la perte en absolu est acceptable. Ce système possède donc les avantages d'un circuit large bande sans en avoir l'inconvénient majeur, qui est un faible rendement dans le cas de l'amplification d'un signal faible bande.

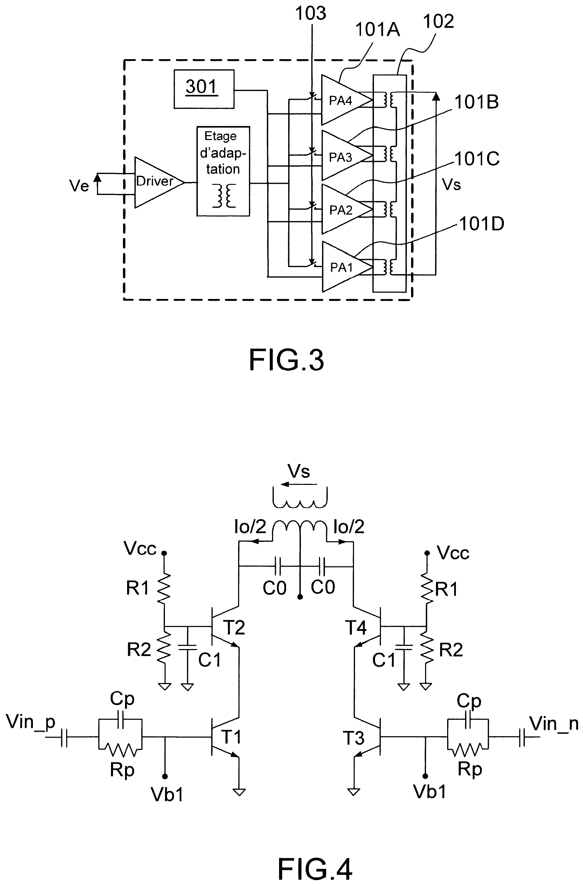

Sur la figure 3, un capteur de température 301 est ajouté. Il permet de déconnecter automatiquement tout ou partie des amplificateurs de puissance dans le cas où la température interne dépasse un seuil. Ce seuil est fonction de la technologie et dépend de la température limite de jonction des transistors. Il sera fixé en tenant compte des capacités de refroidissement que l'on est capable d'installer autour de la puce.

La figure 4 présente un mode de réalisation des différents amplificateurs de puissance. Dans ce mode de réalisation les différentes capacités Cp, C1 et C0 permettent de déterminer la bande d'étalement des fréquences pour laquelle l'amplification du signal est optimale.

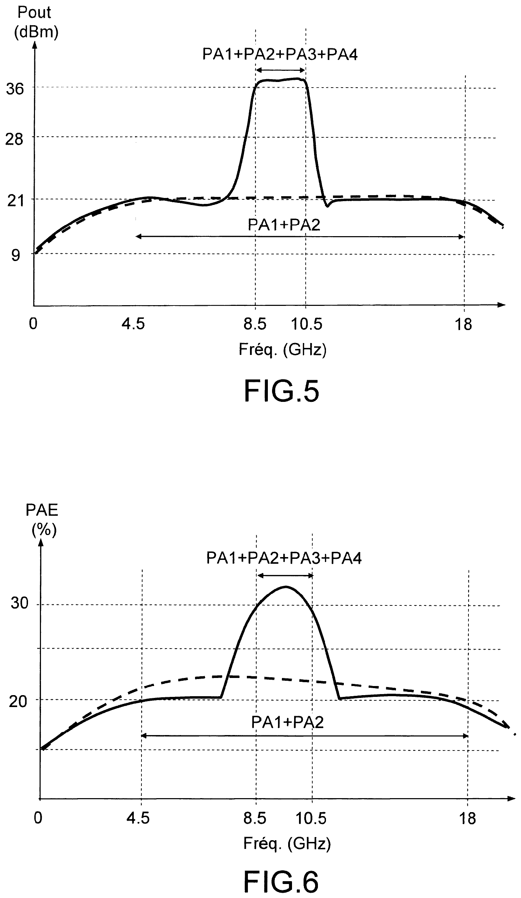

La figure 5 présente la puissance du signal de sortie de ce troisième mode de réalisation du système. Dans ce mode de réalisation deux modes sont disponibles, un mode forte puissance et un mode puissance moyenne. Le mode puissance moyenne correspond à une puissance de 21 dBm et est utilisé dans une bande d'étalement des fréquences allant de la fréquence 4.5GHz à la fréquence 18 GHz. Le mode forte puissance correspond à une puissance de 36 dBm et est utilisé dans une bande d'étalement des fréquences allant de la fréquence 8.5GHz à la fréquence 10.5 GHz.

La figure 6 présente le rendement du troisième mode de réalisation du système. Ce rendement est configurable et adaptable. Le rendement moyen est de 20% et est associé à une consommation de 0.3A. Ce rendement est présent entre la fréquence 4.5GHz et la fréquence 18GHz. Le rendement élevé est de 30% et est associé à une consommation de 3A. Ce rendement est présent entre la fréquence 8.5GHz et la fréquence 10.5GHz.

Ce troisième mode de réalisation permet donc d'optimiser la consommation et la dissipation thermique du système.

Il est aussi possible afin d'améliorer les performances du système de faire commuter la classe des dispositifs d'application entre la classe A et la classe AB par exemple, en fonction des signaux à traiter.

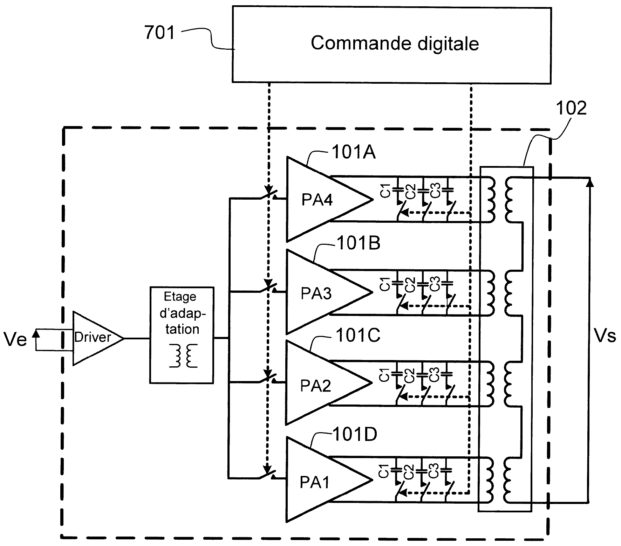

Dans un mode de réalisation les dispositifs d'adaptation sont activables et/ou reconfigurables de manière dynamique, d'une manière présentée figure 7. Ceci permet d'avoir un système d'amplification pouvant s'adapter à l'amplification d'un signal dont la fréquence centrale du signal évolue dans le temps (aussi connu comme signal ou système à saut de fréquence) et de s'adapter à la largeur de la bande utile du signal à amplifier, en optimisant le rendement. Cette fonction est réalisée par exemple par des commandes digitales 701 telles que représentées figure 7.

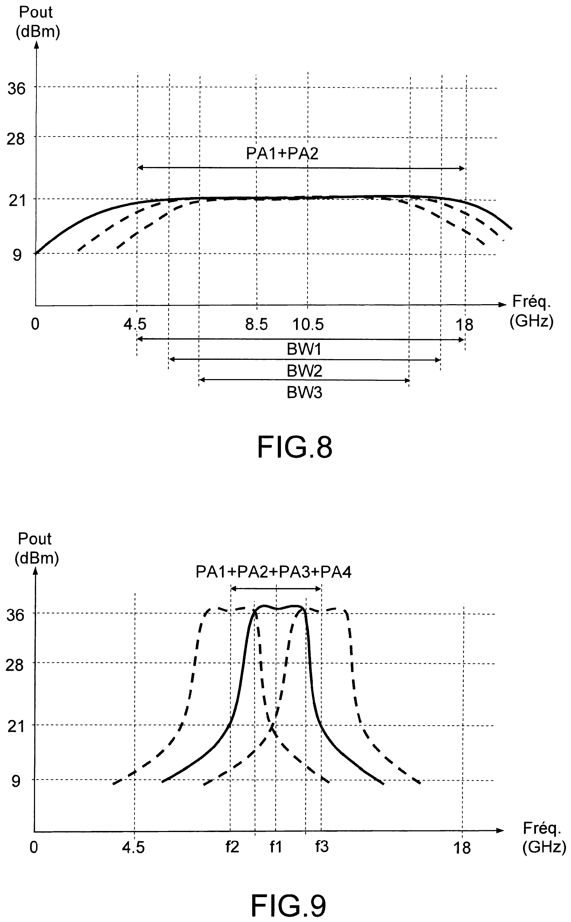

Ainsi ce mode de réalisation permet un changement dynamique de la fréquence centrale. Ce changement permet de « suivre » la fréquence à émettre et de se prémunir de la génération des harmoniques inhérentes à l'émission large bande. Ceci est illustré en particulier sur la figure 9.

Enfin il est aussi possible d'avoir des amplificateurs à bande passante programmable en fonction par exemple du débit de transmission ou de la résolution souhaitée d'une image provenant d'un satellite utilisant un radar à synthèse d'ouverture (connu aussi sous l'acronyme anglais de SAR pour Synthetic Aperture Radar). Dans ce cas il est possible comme cela est présenté sur la figure 8 d'adapter les amplificateurs à activer ou reconfigurer en fonction de la bande passante utile.

## Revendications

1. Système d'amplification de signaux comprenant :
- une entrée (Ve) par laquelle est transmis un signal d'entrée,
- au moins deux moyens (101A et 101B) d'amplification différents, chaque moyen d'amplification étant configuré pour amplifier le signal d'entrée lorsque le moyen d'amplification est activé,
- au moins un moyen (102) de sommation des signaux amplifiés par les au moins deux moyens d'amplification,
- une sortie (Vs) par laquelle est transmis le signal sommé par les moyens de sommation,
- des moyens d'activation/désactivation (103) dynamiques des moyens d'amplification, les moyens d'activation/désactivation étant configurés pour activer ou désactiver un ou plusieurs des au moins deux moyens d'amplification en fonction de la bande d'étalement du signal d'entrée ;
**caractérisé en ce qu'**au moins deux desdits moyens d'amplification ont des bandes passantes différentes, au moins un desdits deux moyens d'amplification est adapté pour amplifier des signaux dont la bande d'étalement des fréquences a une largeur supérieure ou égale à une octave, et **en ce que** le moyen de sommation est un transformateur à distribution active.

2. Système selon la revendication 1 comportant en outre des moyens d'adaptations placés avant les moyens d'amplifications, lesdits moyens d'activation/désactivation étant en outre adaptés pour l'activation/désactivation desdits moyens d'adaptation.

3. Système selon la revendication 1 ou 2 comportant en outre des moyens de reconfiguration desdits deux moyens d'amplification.

4. Système d'amplification selon l'une des revendications précédentes dans lequel au moins un des deux moyens d'amplification est adapté pour amplifier des signaux dont la bande d'étalement des fréquences a une largeur inférieure ou égale à une octave.

5. Système selon l'une des revendications 1 à 4 dans lequel au moins un des moyens d'amplification est réalisé en utilisant du SiGe et au moins un des moyens d'amplification est réalisé en utilisant du GaN.

6. Système selon l'une des revendications 1 à 5 dans lequel au moins deux desdits moyens d'amplification utilisent une classe d'amplification différente.

7. Système selon l'une des revendications 1 à 6 dans lequel lesdits moyens d'activation/désactivation sont adaptés pour l'activation des moyens d'amplification pour lesquels les performances sont optimales pour une bande d'étalement des fréquences associée au signal d'entrée.

8. Système selon l'une des revendications 1 à 7 dans lequel lesdits moyens d'activation/désactivation sont adaptés pour l'activation des moyens d'amplification pour lesquels les performances sont optimales pour une fréquence centrale associée au signal d'entrée.

9. Système selon l'une des revendications 2 à 8 dans lequel au moins un des moyens d'amplification est adapté pour l'amplification de signaux constitués d'une porteuse pure modulée en phase et/ou en amplitude et/ou en fréquence et au moins un des moyens d'amplification et/ou lesdits moyens d'adaptation sont adaptés pour l'amplification de signaux constitués d'une succession d'impulsions.

10. Système selon l'une des revendications 1 à 9 comportant en outre des moyens de mesure (301) de la température interne dudit système et dans lequel lesdits moyens d'activation/désactivation (103) sont adaptés pour activer/désactiver au moins un des moyens d'amplification lorsque ladite température interne dépasse un seuil de température et/ou lesdits moyens de reconfiguration sont adaptés pour reconfigurer au moins un des moyens d'amplification lorsque ladite température interne dépasse un seuil de température.

11. Système selon d'une des revendications 1 à 10 comportant en outre au moins une antenne (104) active à balayage électronique permettant l'émission desdits signaux sommés.

## Patentansprüche

1. Signalverstärkungssystem, umfassend
- einen Eingang (Ve), durch den ein Eingangssignal übertragen wird,
- mindestens zwei verschiedene Verstärkungsmittel (101A und 101B), wobei jedes Verstärkungsmittel dafür konfiguriert ist, das Eingangssignal zu verstärken, wenn das Verstärkungsmittel aktiviert ist,
- mindestens ein Mittel (102) zum Addieren der durch die mindestens zwei Verstärkungsmittel verstärkten Signale,
- einen Ausgang (Vs), durch den das durch die Addiermittel addierte Signal übertragen wird,
- dynamische Aktivierungs-/Deaktivierungsmittel (103) der Verstärkungsmittel, wobei die Aktivierungs-/Deaktivierungsmittel dafür konfiguriert sind, eine oder mehrere der mindestens zwei Verstärkungsmittel in Abhängigkeit von dem Spreizungsband des Eingangssignals zu aktivieren oder deaktivieren;
**dadurch gekennzeichnet, dass** mindestens zwei der Verstärkungsmittel verschiedene Bandbreiten aufweisen, mindestens eines der zwei Verstärkungsmittel dafür geeignet ist, Signale zu verstärken, deren Frequenzspreizungsband eine Größe größer oder gleich einer Oktave aufweist, und dass das Addiermittel ein Wandler mit aktiver Verteilung ist.

2. System nach Anspruch 1, das ferner Anpassungsmittel aufweist, die vor den Verstärkungsmitteln angeordnet sind, wobei die Aktivierungs-/Deaktivierungsmittel ferner für die Aktivierung/Deaktivierung der Anpassungsmittel geeignet sind.

3. System nach Anspruch 1 oder 2, das ferner Rekonfigurationsmittel der zwei Verstärkungsmittel aufweist.

4. Verstärkungssystem nach einem der vorhergehenden Ansprüche, wobei mindestens eines der zwei Verstärkungsmittel dafür geeignet ist, Signale zu verstärken, deren Frequenzspreizungsband eine Größe kleiner oder gleich einer Oktave aufweist.

5. System nach einem der Ansprüche 1 bis 4, wobei mindestens eines der Verstärkungsmittel unter Verwendung von SiGe gefertigt ist und mindestens eines der Verstärkungsmittel unter Verwendung von GaN gefertigt ist.

6. System nach einem der Ansprüche 1 bis 5, wobei mindestens zwei der Verstärkungsmittel eine unterschiedliche Verstärkungsklasse verwenden.

7. System nach einem der Ansprüche 1 bis 6, wobei die Aktivierungs-/Deaktivierungsmittel für die Aktivierung der Verstärkungsmittel angepasst sind, bei denen die Leistungen für ein dem Eingangssignal zugeordnetes Frequenzspreizungsband optimal sind.

8. System nach einem der Ansprüche 1 bis 7, wobei die Aktivierungs-/Deaktivierungsmittel für die Aktivierung der Verstärkungsmittel angepasst sind, bei denen die Leistungen für eine dem Eingangssignal zugeordnete Mittenfrequenz optimal sind.

9. System nach einem der Ansprüche 2 bis 8, wobei mindestens eines der Verstärkungsmittel für die Verstärkung von Signalen geeignet ist, die aus einem reinen Träger, der phasenmoduliert und/oder amplitudenmoduliert und/oder frequenzmoduliert ist, zusammengesetzt sind, und mindestens eines von den Verstärkungsmitteln und/oder den Anpassungsmitteln für die Verstärkung von Signalen geeignet ist, die aus einer Aufeinanderfolge von Impulsen zusammengesetzt sind.

10. System nach einem der Ansprüche 1 bis 9, das ferner Messmittel (301) für die interne Temperatur des Systems aufweist, und wobei die Aktivierungs-/Deaktivierungsmittel (103) zum Aktivieren/Deaktivieren mindestens eines der Verstärkungsmittel geeignet sind, wenn die interne Temperatur eine Schwellentemperatur übersteigt, und/oder die Rekonfigurationsmittel zum Rekonfigurieren mindestens eines der Verstärkungsmittel geeignet sind, wenn die interne Temperatur eine Schwellentemperatur übersteigt.

11. System nach einem der Ansprüche 1 bis 10, das ferner mindestens eine aktive elektronische Abtastantenne (104) aufweist, die die Ausgabe der addierten Signale ermöglicht.

## Claims

1. A signal amplification system comprising:
- an input (Ve) through which an input signal is transmitted,
- at least two different amplification means (101A and 101B), each amplification means being configured to amplify the input signal when the amplification means is activated,
- at least one means (102) of summing the amplified signals by the at least two amplification means,
- an output (Vs) through which is transmitted the signal summed by the summing means,
- dynamic means of activating/deactivating (103) the amplifying means, the activation/deactivation means being configured to activate or deactivate one or more of the at least two amplification means depending on the bandspread of the input signal;
**characterised in that** at least two of said amplification means have different bandwidths, at least one of said two amplification means is adapted to amplify signals the frequency bandspread of which has a width greater than or equal to one octave, and **in that** the summing means is an active distribution transformer.

2. The system according to claim 1 further having adapting means placed before the amplifying means, said activation/deactivation means being further adapted for activation/deactivation of said adapting means.

3. The system according to claim 1 or 2 further having means of reconfiguring said two amplifying means.

4. The amplification system according to one of the preceding claims wherein at least one of the two amplifying means is adapted to amplify signals, the frequency bandspread of which has a width less than or equal to one octave.

5. The system according to one of claims 1 to 4 wherein at least one of the amplifying means is produced using SiGe and at least one of the amplifying means is produced using GaN.

6. The system according to one of claims 1 to 5 wherein at least two of said amplifying means use a different amplification class.

7. The system according to one of claims 1 to 6 wherein said activation/deactivation means are adapted for activating the amplifying means for which the performance is optimal for a frequency bandspread associated with the input signal.

8. The system according to one of claims 1 to 7 wherein said activation/deactivation means are adapted for activating the amplifying means for which the performance is optimal for a centre frequency associated with the input signal.

9. The system according to one of claims 2 to 8 wherein at least one of the amplifying means is adapted for amplifying signals consisting of a pure phase modulated and/or amplitude modulated and/or frequency modulated carrier and at least one of the amplifying means and/or said adapting means are adapted for amplifying signals consisting of a succession of pulses.

10. The system according to one of claims 1 to 9 further having means of measuring (301) the internal temperature of said system and in which said activation/deactivation means (103) are adapted for activing/deactivating at least one of the amplifying means when said internal temperature exceeds a temperature threshold and/or said reconfiguring means are adapted for reconfiguring at least one of the amplifying means when said internal temperature exceeds a temperature threshold.

11. The system according to one of claims 1 to 10 further having at least one active electronically-scanned array (104) enabling the transmission of said summed signals.
